(19) Europäisches Patentamt
European Patent Office
Office européen des brevets

(11) **EP 0 527 043 B1**

(12) **EUROPEAN PATENT SPECIFICATION**

(45) Date of publication and mention
of the grant of the patent:
**22.01.1997 Bulletin 1997/04**

(51) Int Cl.⁶: **G02B 17/08**

(21) Application number: **92307152.6**

(22) Date of filing: **05.08.1992**

(54) **Catadioptric reduction projection optical system**

Verkleinerndes katadioptrisches Projektionssystem

Système de projection en réduction catadioptrique

(84) Designated Contracting States:
**DE FR GB**

(30) Priority: **05.08.1991 JP 195500/91**

(43) Date of publication of application:
**10.02.1993 Bulletin 1993/06**

(73) Proprietor: **NIKON CORPORATION**
**Tokyo (JP)**

(72) Inventor: **Suenaga, Yutaka**
**Yokohama-shi, Kanagawa-ken (JP)**

(74) Representative: **Burke, Steven David et al**
**R.G.C. Jenkins & Co.**
**26 Caxton Street**
**London SW1H 0RJ (GB)**

(56) References cited:
**US-A- 3 285 128         US-A- 4 747 678**
**US-A- 4 812 028**

**Description**

BACKGROUND OF THE INVENTION

Field of the Invention

The present invention relates to a catadioptric optical system having a reflection surface and a refraction surface, and more particularly to an image forming optical system for reduction projection.

Related Background Art

Various optical systems for projecting and exposing a mask pattern to a photoresist on a wafer to manufacture an integrated circuit such as an LSI have been proposed. It is known that an aberration is well corrected at a relatively large aperture in a Dyson type catadioptric optical system. However, since the focusing magnification in the Dyson type catadioptric optical system is unity, there is a limit in the transfer of a fine pattern.

As an optical system having a reduction factor suitable for the manufacture of a semiconductor device having a finer pattern, an optical system which is a modification of the Dyson type catadioptric optical system is disclosed in U.S.P. 4,747,678 (corresponding to Japanese Laid-Open Patent Application No. 63-163319) and U.S.P. 4,953,960 (corresponding to Japanese Laid-Open Patent Application No. 2-66510).

The optical system disclosed in U.S.P. 4,747,678 which permits the reduction projection allows the reduction focusing of a ring-shaped view field. Basically, it comprises three concave mirrors and a convex mirror and is used as a light exposure device for microlithography. Accordingly, it uses a very complex optical construction of a combination of a number of lenses.

The reduction projection optical system disclosed in U.S.P. 4,953,960 comprises a combination of a concave mirror and a lens system. Since the reduction is attained by one time of focusing, the aberration is large and a combination of a number of lenses is needed to correct the aberration. Since it is essential to provide a large scale beam splitter such as a half mirror in a light path, the loss of light intensity is more than 75 % and the increase of exposure time due to the loss of light intensity causes a fatal shortcoming of the reduction of throughput in the manufacturing process of the semiconductor device. Further, stray light which causes flare and non-uniformity in illumination occurs in the large beam splitter in the light path, and it is difficult to manufacture a large semitransparent plane.

Reference is made to US-A-4812028 which discloses a catadioptric projection optical system suitable for projection of a micropattern object and which is capable of performing reduction projection. The projection optical system comprises first and second optical subsystems which are combined to set a Petzval sum to zero. A first optical system forms a reduced image of an object, and a second optical subsystem forms a further reduced object image from the image formed by the first optical subsystem.

SUMMARY OF THE INVENTION

It would be desirable to provide a reduction projection optical system which solves problems encountered in the prior art optical systems and which is simple in structure and has a good image-forming ability as a projection optical system for use in semiconductor fabrication.

The present invention provides a catadioptric projection system for forming a reduced image of an object, the system comprising in a light path sequence from an object:

a first sub-system for generating a partially reduced image of the object, the first sub-system comprising a first group of lenses of positive refractive power, a first concave reflector, and a second group of lenses of positive refractive power; and
a second sub-system for generating from said partially reduced image the said reduced image, the second sub-system comprising a second concave reflector and a third group of lenses having a positive refractive power;
wherein the system comprises a third reflector positioned so as to direct light from the first sub-system to the second sub-system.

With such a system in which each of the first and second optical sub-systems (referred to herein also as partial optical systems) comprises a concave reflector having a primary refractive power, and a group of lenses (second group of lenses or third group of lenses) having the positive refractive power arranged in the vicinity of the image formed by the concave reflector, each sub-system performs the reduced image-forming. Accordingly, the entire system can attain a desired reduction factor without imparting large burden of aberration correction to each of the optical sub-systems. As a result, a good image-forming ability can be attained with a simple optical construction, a large numerical aperture (N.A.) can be attained and the transfer of a finer pattern can be attained.

In the optical system of the present invention, since the light path is completely isolated by the third reflector (light path deflection reflector mirror, e.g. a planar mirror) arranged between the first optical sub-system and the second optical sub-system, the third reflector may be a perfect reflection mirror and a beam splitter such as a semi-transmissive mirror shown in U.S.P. 4,953,960 mentioned above is not necessary. As a result, loss of light intensity can be very small and a possibility of stray light such as flare is low.

In the preferred embodiment, the respective optical members except the light path deflecting planar reflection mirror arranged between the first optical sub-system and the second optical sub-system have centers of curvature on the same optical axis.

The construction of the present invention essentially differs from that of the optical system disclosed in U.S.P. 4,747,678 in that the former does not need a convex reflection mirror as an optical element. The prior art optical system uses a correction method of cancelling out a negative Petzval sum generated by a concave reflection mirror by a convex reflection mirror and performing auxiliary aberration correction by a deflection system. In the preferred embodiment of present invention, correction of the negative Petzval sum generated by the concave reflector is cancelled out by a positive Petzval sum in the second and third groups of lenses which are lens groups of positive refractive power. Accordingly, with this arrangement, the positive refractive powers of the second and third groups of lenses can be fairly large and they are positively utilized.

Where spherical mirror are used as the concave reflectors, it is preferable to arrange a fourth group of lenses ($G_4$ in the preferred embodiment) for correcting aberration between the second concave mirror and the second group of lenses in the second partial optical system.

Further preferred features of the present invention are now described in detail. The second concave reflector in the second partial optical system preferably has a small magnification factor although it is close to unity magnification in order to facilitate the separation of the light path by the planar reflection mirror. Specifically, it is preferable that the following condition is met:

$$-1.5 < \beta_{M2} < -1.0$$

where $\beta_{M2}$ is the magnification of the second concave reflector.

As a result, a position of an object image formed by the first partial optical system is closer to the second concave reflector than a position of an image formed by the second partial optical system, so that the interference of the light path is prevented even for a light beam of a large numerical aperture. When $\beta_{M2}$ exceeds the upper limit, the magnification of the second concave reflector exceeds unity and the separation of the light path is difficult to attain. Conversely, when the magnification exceeds the lower limit, it is difficult for the second optical sub-system to attain the desired reduction factor, and the burden of the first optical sub-system increases and a complex construction is required to correct the aberration.

The first concave reflector preferably has a relatively large reduction factor and plays an important role to balance the compactness of the entire system and the correction of aberration. It is preferable to meet the following condition.

$$0.7 < \beta_{M1} < -0.3$$

where $\beta_{M1}$ is the reduction factor of the first concave reflector $M_1$.

The balance of aberration of the groups of lenses is now discussed. The first group of lenses is arranged in the vicinity of the object surface and functions as a so-called view field lens and also corrects direction aberration. The second and third groups of lenses, respectively, have large positive refractive powers as described above, contribute to the formation of the reduced image and positively function to correct the Petzval sum; the negative distortion aberration generated therein is corrected by the positive distortion aberration of the first group of lenses. The fourth group of lenses provided provisionally in the second optical sub-system is effective to correct higher order spherical aberration. Where the concave reflectors, particularly the first concave reflector which shares a large portion of the reduction factor are non-spherical rather than spherical, the fourth group of lenses $G_4$ may be omitted.

BRIEF DESCRIPTION OF THE DRAWINGS

Fig. 1 shows a light path of a first embodiment of a catadioptric reduction projection optical system of the present invention, and

Fig. 2 shows a light path of a second embodiment of the present invention.

DETAILED DESCRIPTION OF THE PREFERRED EMBODIMENTS

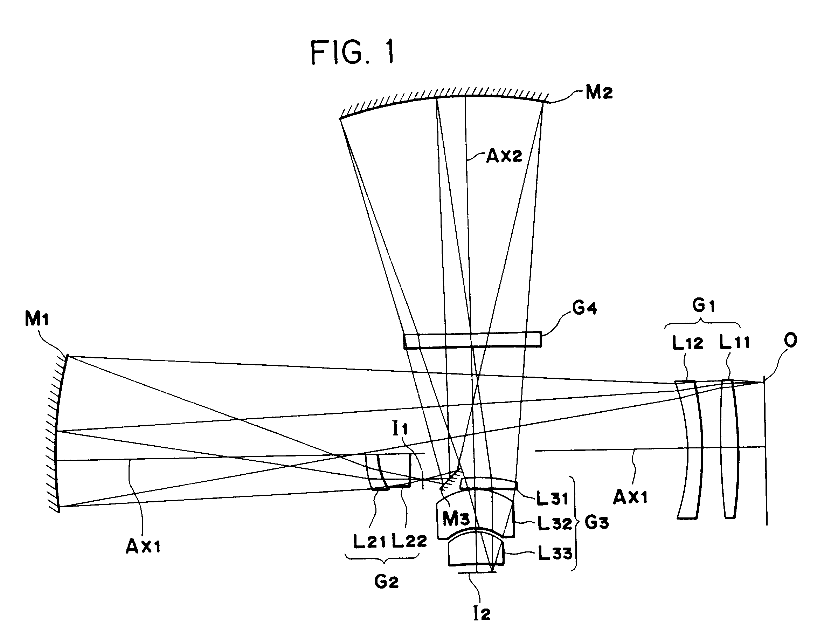

Preferred embodiments of the present invention are now explained. Fig. 1 shows light path for a first embodiment of the present invention. As shown, a light beam from an object surface passes through a first group of lenses $G_1$ comprising a biconvex positive lens $L_{11}$ and a negative meniscus lens $L_{12}$ having a convex surface thereof faced to the object, is directed to a first concave reflection mirror $M_1$ where it is reflected and reduced by a factor $\beta_{M1}$, and is directed to a second group of lenses $G_2$ comprising a negative meniscus lens $L_{21}$ having a convex surface thereof faced to the first concave reflection mirror $M_1$ and a positive lens $L_{22}$ having a stronger radius of curvature on a surface facing the first concave reflection mirror $M_1$. It is further reduced by the second group of lenses $G_2$ to form a primary image $I_1$. The light beam from the primary image $I_1$ is reflected by the light path deflecting planar reflection mirror $M_3$, directed to a second concave reflection mirror $M_2$ and is reflected thereby so that it is magnified by a factor which is slightly larger than unity. It is reduced by a third group of lenses $G_3$ comprising a positive lens $L_{31}$ having a stronger radius of curvature or a surface facing the second concave reflection mirror $M_2$, a meniscus lens $L_{32}$ having a concave surface faced to the second concave reflection mirror $M_2$ and a positive lens $L_{33}$ having a stronger radius of curvature on a surface facing the second concave reflection mirror $M_2$ so that a secondary image $I_2$ which is a reduction of the primary image $I_1$ is formed. A negative lens having a weak negative refractive power is arranged, as a fourth group of lenses $G_4$, between the second concave reflection mirror $M_2$ and the third group of lenses $G_3$, to correct higher order spherical aberration.

In the above construction, the first group of lenses $G_1$, the first concave reflection mirror $M_1$ and the second group of lenses $G_2$ form the first partial optical system, the second concave reflection mirror $M_2$, the third group of lenses $G_3$ and the fourth group of lenses $G_4$ form the second partial optical system. The second group of lenses $G_2$ in the first partial optical system is provided on only one side of an optical axis Ax1 of the first partial optical system so that it does not interrupt the light beam directed to the first concave reflection mirror $M_1$ and condenses only the reflected light from the first concave reflection mirror $M_1$. The light path deflecting planar reflection mirror $M_3$ is obliquely arranged at an angle of 45° to the optical axis Ax1 of the first partial optical system in the vicinity of the third group of lenses $G_3$, and the optical axis Ax2 of the second partial optical system is orthogonal to the optical axis Ax1 of the first partial optical system. Since the planar reflection mirror $M_3$ is arranged in the vicinity of the primary image $I_1$, more specifically exit light side vicinity of the primary image $I_1$, the dimension thereof is small and it can be arranged by cutting off a portion of the first positive lens $L_{31}$ in the third group of lenses $G_3$. The fourth group of lenses $G_4$ in the second partial optical system is arranged not to interrupt the light path of the first partial optical system. While the angle of inclination of the planar reflection mirror $M_3$ is 45° in the present embodiment, it may be any angle so long as the separation of the light path is attained.

The first embodiment has a reduction factor of +0.25 or 1/4 as a whole and a numerical aperture (N.A.) of 0.4 in a ring-shaped view field centered at an arc having a radius of 25 mm from the optical axis.

Data of the first embodiment are shown in a table below, in which signs of the refractive index and the plane-to-plane distance are reversed by the reflection by the concave reflection mirror. The position of the third reflection mirror $M_3$ for deflecting the light path is omitted since it is not essential in the optical design.

Table 1

Data of First Embodiment

| No. | Radius of Curvature | Plane-to-Plane Distance | Refractive Index | | |
|---|---|---|---|---|---|
| | (Object Plane) | 47.063 | 1.000 | | |
| 1 | 677.873 | 25.000 | 1.500 | $L_{11}$ | $G_1$ |
| 2 | −988.280 | 22.657 | 1.000 | | |
| 3 | 591.515 | 25.020 | 1.500 | $L_{12}$ | |
| 4 | 288.196 | 990.000 | 1.000 | | |
| 5 | −744.372 | −479.502 | − 1.000 | $M_1$ | |
| 6 | −131.046 | − 12.701 | − 1.500 | $L_{21}$ | $G_2$ |
| 7 | − 83.678 | −3.000 | − 1.000 | | |
| 8 | − 88.873 | − 53.909 | − 1.500 | $L_{22}$ | |
| 9 | 742.557 | −250.755 | − 1.000 | | |
| 10 | 2588.139 | − 20.000 | − 1.500 | $G_4$ | |
| 11 | −24840.890 | −376.150 | − 1.000 | | |
| 12 | 681.247 | 376.150 . | 1.000 | $M_2$ | |
| 13 | −24840.890 | 20.000 | 1.500 | $G_4$ | |
| 14 | 2588.139 | 203.875 | 1.000 | | |
| 15 | 277.553 | 16.500 | 1.500. | $L_{31}$ | $G_3$ |
| 16 | 621.605 | 0.0500 | 1.000 | | |
| 17 | 103.075 | 61.334 | 1.500 | $L_{32}$ | |
| 18 | 74.101 | 5.000 | 1.000 | | |
| 19 | 81.631 | 54.747 | 1.500 | $L_{33}$ | |
| 20 | 461.143 | 9.946 | 1.000 | | |

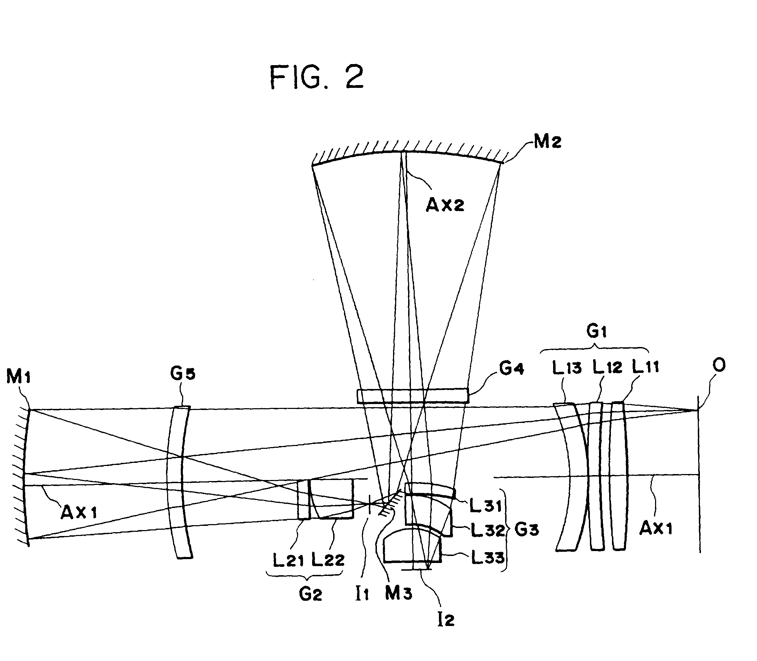

A second embodiment of the present invention shown in Fig. 2 is basically same as the first embodiment but the overall optical system is more compact and the first and second concave reflection mirrors $M_1$ and $M_2$ are arranged closer to the object surface 0 and the secondary image $I_2$ and the diameters thereof are smaller. In order to correct the aberrations generated by the compaction, a meniscus lens having a convex surface thereof faced to the first concave reflection mirror $M_1$ is arranged as a fifth group of lenses $G_5$ between the first concave reflection mirror $M_1$ and the second group of lenses $G_2$ in the second partial optical system, and a biconcave positive lens $L_{11}$, a meniscus lens $L_{12}$ having a concave surface thereof faced to the object surface and a meniscus lens $L_{12}$ having a convex surface thereof faced to the object surface are provided as the first group of lenses $G_1$.

The second embodiment has a reduction factor of +0.25 or 1/4 as a whole and an numerical aperture (N.A.) of 0.4 in a ring-shaped view field centered at an arc having a radius of 25 mm from the optical axis.

Data of the second embodiment are shown in a table below.

## Table 2

### Data of Second Embodiment

| No. | Radius of Curvature | Plane-to-Plane Distance | Refractive Index | |
|---|---|---|---|---|
| | (Object Plane) | 112. 472 | 1. 000 | |
| 1 | 977. 575 | 30. 000 | 1. 500 | $L_{11}$ $G_1$ |
| 2 | $-$ 1030. 934 | 15. 000 | 1. 000 | |
| 3 | $-$ 1446. 147 | 20. 000 | 1. 500 | $L_{12}$ |
| 4 | $-$ 1878. 184 | 0. 500 | 1. 000 | |
| 5 | 316. 624 | 30. 000 | 1. 500 | $L_{13}$ |
| 6 | 289. 149 | 613. 035 | 1. 000 | |
| 7 | $-$407. 188 | 20. 000 | 1. 500 | $G_5$ |
| 8 | $-$469. 137 | 226. 192 | 1. 000 | |

| | | | | |
|---|---|---|---|---|
| 9 | −692.557 | −226.192 | − 1.000 | M₁ |
| 10 | −469.137 | − 20.000 | − 1.500 | G₅ |
| 11 | −407.188 | −182.064 | − 1.000 | |
| 12 | − 6117.578 | − 20.000 | − 1.500 | L₂₁ G₂ |
| 13 | 3775.716 | −0.500 | − 1.000 | |
| 14 | −136.376 | − 71.120 | − 1.500 | L₂₂ |
| 15 | 881.988 | −212.075 | − 1.000 | |
| 16 | 2473.277 | − 20.000 | − 1.500 | G₄ |
| 17 | −44915.848 | −371.392 | − 1.000 | |
| 18 | 608.000 | 371.392 | 1.000 | M₂ |
| 19 | −44915.848 | 20.000 | 1.500 | G₄ |
| 20 | 2473.277 | 125.565 | 1.000 | |
| 21 | 254.431 | 17.000 | 1.500 | L₃₁ G₃ |
| 22 | 452.400 | 0.010 | 1.000 | |
| 23 | 94.027 | 46.970 | 1.500 | L₃₂ |
| 24 | 69.588 | 5.000 | 1.000 | |
| 25 | 76.436 | 51.600 | 1.500 | L₃₃ |
| 26 | 458.225 | 11.117 | 1.000 | |

In the above embodiments, the first concave reflection mirror $M_1$ and the second concave reflection mirrors $M_2$ are spherical although they may be non-spherical such as oval. In this case, the fourth group of lenses $G_4$ may be omitted as described above.

In accordance with the present invention, the catadioptric reduction projection optical system which is simpler in construction than the prior art optical system, and has a larger numerical aperture, a better image-forming ability and a wider illumination field or a wider exposure field is provided. In spite of the large numerical aperture and the wide exposure field, the plane accuracy and the allowance of eccentricity are less severe because of smaller size of the optical elements. Accordingly, it is very useful for a projection optical system for fabricating a semiconductor device.

**Claims**

1. A catadioptric projection system for forming a reduced image of an object, the system comprising in a light path sequence from an object:

   a first sub-system for generating a partially reduced image of the object, the first sub-system comprising a first group of lenses ($G_1$) of positive refractive power, a first concave reflector ($M_1$), and a second group of lenses ($G_2$) of positive refractive power;

7

a second sub-system for generating from said partially reduced image the said reduced image, the second sub-system comprising a second concave reflector ($M_2$) and a third group of lenses ($G_3$) having a positive refractive power; and

wherein the system further comprises a third reflector ($M_3$) positioned so as to direct light from the first sub-system to the second sub-system.

2. A system according to claim 1, wherein said first concave reflector ($M_1$) has a reduction factor and said second concave reflector mirror ($M_2$) has a magnification factor.

3. A system according to claim 1 or 2, wherein the magnification factor ($\beta_{M2}$) of said second concave reflector ($M_2$) meets the condition of:

$$-1.5 < \beta_{M2} < -1.0$$

4. A system according to any preceding claim, wherein the reduction factor ($\beta_{M1}$) of said first concave reflector ($M_1$) meets the condition of:

$$-0.7 < \beta_{M1} < -0.3$$

5. A system according to any preceding claim, wherein said first group of lenses ($G_1$) is arranged in the vicinity of the object plane, functions as a view field lens and corrects distortion aberration, and said second group of lenses ($G_2$) and said third group of lenses ($G_3$) contribute to the formation of the reduced image and function to correct a Petzval sum.

6. A system according to any preceding claim, wherein said first concave reflector ($M_1$) and said second concave reflector ($M_2$) are spherical mirrors, and said second optical sub-system comprises a fourth group of lenses ($G_4$) between said second concave reflector ($M_2$) and said third group of lenses ($G_3$).

7. A system according to any preceding claim, wherein the lens groups ($G_1$; $G_2$; $G_3$; $G_4$) each include one or more discrete lenses.

8. A system according to claim 7, wherein said first group of lenses ($G_1$) includes a biconvex positive lens ($L_{11}$) and a negative meniscus lens ($L_{12}$) having a convex surface thereof faced to the object plane, said second group of lenses ($G_2$) includes a negative meniscus lens ($L_{21}$) having a convex surface thereof faced to said first concave reflector ($M_1$) and a positive lens ($L_{22}$) having a stronger radius of curvature on a plane facing said first concave reflector ($M_1$), and said third group of lenses ($G_3$) includes a positive lens ($L_{31}$) having a stronger radius of curvature on a surface facing said second concave reflector ($M_2$), a meniscus lens ($L_{32}$) having a convex surface thereof faced to said second concave reflector ($M_2$) and a positive lens ($L_{33}$) having a stronger radius of curvature on a plane facing said second concave reflector ($M_2$) .

9. A system according to claim 7, wherein said first group of lenses ($G_1$) includes a biconvex positive lens ($L_{11}$), a meniscus lens ($L_{12}$) having a concave surface thereof faced to the object plane and a meniscus lens ($L_{13}$) having a convex surface thereof faced to the object plane.

10. A system according to any preceding claim, wherein the third reflector ($M_3$) comprises a planar mirror.

11. A system according to any preceding claim, wherein the first optical sub-system comprises only one reflector ($M_1$).

12. A system according to any preceding claim, wherein the second optical sub-system comprises only one reflector ($M_2$).

**Patentansprüche**

1. Katadioptrisches Projektionssystem zum Erzeugen eines verkleinerten Bildes eines Objektes, wobei das System in einem Strahlengang vom Objekt aus in Folge umfaßt

- ein erstes Untersystem zum Erzeugen eines partiell verkleinerten Bildes des Objektes, wobei das erste Untersystem umfaßt

-- eine erste Linsengruppe ($G_1$) positiver Brechkraft,
-- einen ersten Konkavreflektor ($M_1$) und
-- eine zweite Linsengruppe ($G_2$) positiver Brechkraft;

- ein zweites Untersystem zum Erzeugen des verkleinerten Bildes aus dem partiell verkleinerten Bild, wobei das zweite Untersystem umfaßt

-- einen zweiten Konkavreflektor ($M_2$) und
-- eine dritte Linsengruppe ($G_3$) positiver Brechkraft; und

- wobei das System des weiteren einen so angeordneten dritten Reflektor ($M_3$) aufweist, daß Licht aus dem ersten Untersystem zum zweiten Untersystem gerichtet wird.

2. System nach Anspruch 1, bei dem

- der erste Konkavreflektor ($M_1$) einen Verkleinerungsfaktor und der zweite Konkavreflektor ($M_2$) einen Vergrößerungsfaktor besitzt.

3. System nach Anspruch 1 oder 2, bei dem
der Vergrößerungsfaktor ($\beta_{M2}$) des zweiten Konkavreflektors ($M_2$) die Bedingung erfüllt:

$$-1,5 < \beta_{M2} < -1,0.$$

4. System nach einem vorangegangenen Anspruch, bei dem
der Verkleinerungsfaktor ($\beta_{M1}$) des ersten Konkavreflektors ($M_1$) die Bedingung erfüllt:

$$-0,7 < \beta_{M1} < -0,3.$$

5. System nach einem vorangegangenen Anspruch, bei dem

- die erste Linsengruppe ($G_1$) in der Nähe der Objektebene angeordnet ist, als Bildfeldlinse fungiert und die Verzeichnungsaberration korrigiert und
- die zweite Linsengruppe ($G_2$) und die dritte Linsengruppe ($G_3$) zur Erzeugung des verkleinerten Bildes beitragen und zur Korrektur einer Petzval-Summe fungieren.

6. System nach einem vorangegangenen Anspruch, bei dem

- der erste Konkavreflektor ($M_1$) und der zweite Konkavreflektor ($M_2$) sphärische Spiegel sind und
- das zweite optische Untersystem eine vierte Linsengruppe ($G_4$) zwischen zweitem Konkavreflektor ($M_2$) und dritter Linsengruppe ($G_3$) aufweist.

7. System nach einem vorangegangenen Anspruch, bei dem
die Linsengruppen ($G_1$; $G_2$; $G_3$; $G_4$) je eine oder mehrere diskrete Linsen einschließen.

8. System nach Anspruch 7, bei dem

- die erste Linsengruppe ($G_1$) einschließt

-- eine positive Bikonvexlinse ($L_{11}$) und eine negative Meniskuslinse ($L_{12}$) mit einer der Objektebene zugewandten konvexen Fläche,

- die zweite Linsengruppe ($G_2$) einschließt

-- eine negative Meniskuslinse ($L_{21}$) mit einer dem ersten Konkavreflektor ($M_1$) zugewandten konvexen Fläche und eine positive Linse ($L_{22}$), die auf einer dem ersten Konkavreflektor ($M_1$) zugewandten Ebene einen stärkeren Krümmungsradius hat, und

- die dritte Linsengruppe ($G_3$) einschließt

-- eine positive Linse ($L_{31}$) mit einer stärker gekrümmten, dem zweiten Konkavreflektor ($M_2$) zugewandten Fläche, eine Meniskuslinse ($L_{32}$) mit einer dem zweiten Konkavreflektor ($M_2$) zugewandten konvexen Fläche und eine positive Linse ($L_{33}$) mit einem stärkeren Krümmungsradius auf einer dem zweiten Konkavreflektor ($M_2$) zugewandten Ebene.

9. System nach Anspruch 7, bei dem
die erste Linsengruppe ($G_1$) einschließt

- eine positive Bikonvexlinse ($L_{11}$), eine Meniskuslinse ($L_{12}$) mit konkaver Vorderfläche (d. i. die der Objektebene zugewandte Fläche) und eine Meniskuslinse ($L_{13}$) mit konvexer Vorderfläche.

10. System nach einem vorangegangenen Anspruch, bei dem
der dritte Reflektor ($M_3$) einen Planarspiegel umfaßt.

11. System nach einem vorangegangenen Anspruch, bei dem
das erste optische Untersystem nur einen Reflektor ($M_1$) umfaßt.

12. System nach einem vorangegangenen Anspruch, bei dem
das zweite optische Untersystem nur einen Reflektor ($M_2$) umfaßt.


**Revendications**

1. Système de projection catadioptrique pour former une image réduite d'un objet, le système comprenant en séquence dans un trajet lumineux issu d'un objet:

un premier sous-système pour générer une image partiellement réduite de l'objet, le premier sous-système comprenant un premier groupe de lentilles ($G_1$) à pouvoir de réfraction positif, un premier réflecteur concave ($M_1$) et un deuxième groupe de lentilles ($G_2$) à pouvoir de réfraction positif, et
un deuxième sous-système pour générer à partir de ladite image partiellement réduite ladite image réduite, le deuxième sous-système comprenant un deuxième réflecteur concave ($M_2$) et un troisième groupe de lentilles ($G_3$) à pouvoir de réfraction positif,
le système comprenant par ailleurs un troisième réflecteur ($M_3$) disposé de manière à diriger la lumière du premier sous-système au deuxième sous-système.

2. Système selon la revendication 1, dans lequel ledit premier réflecteur concave ($M_1$) a un facteur de réduction et ledit deuxième miroir réflecteur concave ($M_2$) a un facteur d'agrandissement.

3. Système selon la revendication 1 ou 2, dans lequel le facteur d'agrandissement ($\beta_{M2}$) dudit deuxième réflecteur concave ($M_2$) répond à la condition :

$$-1,5 < \beta_{M2} < -1,0.$$

4. Système selon l'une quelconque des revendications précédentes, dans lequel le facteur de réduction ($\beta_{M1}$) dudit premier réflecteur concave ($M_1$) répond à la condition :

$$-0,7 < \beta_{M1} < -0,3.$$

5. Système selon l'une quelconque des revendications précédentes, dans lequel Ledit premier groupe de lentilles ($G_1$) est agencé au voisinage du plan objet, joue le rôle de lentille du champ de vue et corrige également l'aberration de distorsion et ledit deuxième groupe de lentilles (G$_2$) et ledit troisième groupe de lentilles (G$_3$) contribuent à la formation de l'image réduite et corrigent la somme de Petzval.

6. Système selon l'une quelconque des revendications précédentes, dans lequel ledit premier réflecteur concave (M$_1$) et ledit deuxième réflecteur concave (M$_2$) sont des miroirs sphériques, et ledit deuxième sous-système optique comprend un quatrième groupe de lentilles (G$_4$) entre ledit deuxième réflecteur concave (M$_2$) et ledit troisième groupe de lentilles (G$_3$).

7. Système selon l'une quelconque des revendications précédentes, dans lequel les groupes de lentilles (G$_1$; G$_2$; G$_3$; G$_4$) comprennent chacune une ou plusieurs lentilles discrètes.

8. Système selon la revendication 7, dans lequel ledit premier groupe de lentilles (G$_1$) comprend une lentille positive biconvexe (L$_{11}$) et un ménisque négatif (L$_{12}$) ayant sa surface convexe en regard du plan objet, ledit deuxième groupe de lentilles (G$_2$) comprend un ménisque négatif (L$_{21}$) ayant sa surface convexe en regard dudit premier réflecteur concave (M$_1$) et une lentille positive (L$_{22}$) ayant un rayon de courbure plus grand sur un plan en regard dudit premier réflecteur concave (M$_1$), et ledit troisième groupe de lentilles (G$_3$) comprend une lentille positive (L$_{31}$) ayant un rayon de courbure plus grand sur une surface en regard dudit deuxième réflecteur concave (M$_2$), un ménisque (L$_{32}$) ayant sa surface convexe en regard dudit deuxième réflecteur concave (M$_2$) et une lentille positive (L$_{33}$) ayant une courbure plus forte sur la surface en regard dudit deuxième réflecteur concave (M$_2$).

9. Système selon la revendication 7, dans lequel ledit premier groupe de lentilles (G$_1$) comprend une lentille positive biconvexe (L$_{11}$), un ménisque (L$_{12}$) ayant sa surface concave en regard du plan objet et un ménisque (L$_{13}$) ayant sa surface convexe en regard du plan objet.

10. Système selon l'une quelconque des revendications précédentes, dans lequel le troisième réflecteur (M$_3$) comprend un miroir plan.

11. Système selon l'une quelconque des revendications précédentes, dans lequel le premier sous-système optique ne comprend qu'un seul réflecteur (M$_1$).

12. Système selon l'une quelconque des revendications précédentes, dans lequel le deuxième sous-système optique ne comprend qu'un seul réflecteur (M$_2$).

FIG. 1

EP 0 527 043 B1

# FIG. 2

EP 0 527 043 B1